**Europäisches Patentamt**

**European Patent Office**

**Office européen des brevets**

(19)

(11) Veröffentlichungsnummer : **0 303 953 B1**

(12) # EUROPÄISCHE PATENTSCHRIFT

(45) Veröffentlichungstag der Patentschrift :
08.05.91 Patentblatt 91/19

(51) Int. Cl.⁵ : **G01R 33/54, G01R 33/56**

(21) Anmeldenummer : **88112979.5**

(22) Anmeldetag : **10.08.88**

(54) Verfahren zum Codieren und Darstellen von n Parametern bei der mehrdimensionalen Fourier-NMR-Spektroskopie.

(30) Priorität : **13.08.87 DE 3726932**

(43) Veröffentlichungstag der Anmeldung :
**22.02.89 Patentblatt 89/08**

(45) Bekanntmachung des Hinweises auf die Patenterteilung :
**08.05.91 Patentblatt 91/19**

(84) Benannte Vertragsstaaten :
**CH DE FR GB LI**

(56) Entgegenhaltungen :
**WO-A-87/01201**
**DE-A- 3 445 689**
**DE-A- 3 528 894**
**DE-A- 3 627 750**

(56) Entgegenhaltungen :
**GB-A- 2 173 001**
**MAGNETIC RESONANCE IN MEDICINE, Band 2, 1985, Academic Press Inc. FEINBERG DAVID et al. "Magnetic Resonance Imaging the Velocity Vector Components of Flid Flow." Seiten 555-566**

(73) Patentinhaber : **Spectrospin AG**
**Industriestrasse 26**
**CH-8117 Zürich-Fällanden (CH)**

(72) Erfinder : **Hennig, Jürgen, Dr.**
**Johann-von-Weerth-Strasse 12**
**W-7800 Freiburg (DE)**

(74) Vertreter : **KOHLER SCHMID + PARTNER,**
**Patentanwälte**
**Ruppmannstrasse 27**
**W-7000 Stuttgart 80 (DE)**

**Beschreibung**

Die Erfindung betrifft ein Verfahren mit den im Oberbegriff des Anspruches 1 genannten Merkmalen.

Ein solches Verfahren ist aus der DE-A-34 45 689 bekannt. Bei diesem bekannten Verfahren werden Impulsfolgen verwendet, die hintereinander ein direktes Spin-Echosignal und ein stimuliertes Spin-Echosignal liefern. Diese zwei Datensätzen zugeordneten Signale werden getrennt von einander einer Fourier-Transformation unterworfen, so daß sie unterschiedliche Bilder liefern, durch deren Vergleich Rückschlüsse auf den codierten Parameter, beispielsweise die Fließgeschwindigkeit einer Substanz, gezogen werden können. Durch Differenzbildung der durch die Fourier-Transformation erhaltenen Daten läßt sich auch unmittelbar eine Fluß- oder Strömungsdarstellung in Differenzbildern erhalten.

Ein ähnliches Verfahren zur Messung der Strömungsgeschwindigkeit von Flüssigkeiten ist auch in Magnetic Resonance in Medicine, Vol. 2, 1985, Seiten 555 bis 566, offenbart. Aus dem Journal of Magnetic Resonance, Vol. 70, 1986, Seiten 361 bis 368, ist es bekannt, Änderungen der magnetischen Suszeptibilität durch eine Phasenänderung aufeinanderfolgender Signale zu erfassen, während GB-A-21 73 001 die Messung der Verteilung des primären Magnetfeldes behandelt.

Allen diesen Verfahren ist gemeinsam, daß die aufeinanderfolgenden ersten und zweiten Signale zwei verschiedenen Datensätzen angehören und die Größe des gesuchten Parameters durch eine Linearkombination der beiden Datensätze erhalten wird. Zur Bildung dieser Linearkombination ist es erforderlich, daß zwei voneinander unabhängige Signalsätze aufgenommen und dann voneinander subtrahiert werden, bevor das Differenzsignal einer Fourier-Transformation unterworfen wird, oder aber daß die durch die Fourier-Transformation erhaltenen Datensignale voneinander subtrahiert werden. Eine solche Linearkombination führt jedoch nur dann zu korrekten Ergebnissen, wenn die Erzeugung der Signale der beiden Datensätze mit hoher Reproduzierbarkeit erfolgt. Besonders bedeutungsvoll ist die Tatsache, daß es entscheidend auf die Amplitude der beiden Signale ankommt. Schon geringe Amplitudenschwankungen können zu einer erheblichen Verfälschung des zu ermittelnden Parameters führen.

Es ist zwar aus der DE-A-35 28 895 auch schon bekannt, zwei Datensätze zu erzeugen, die mit einer Phaseninformation entsprechend zwei zu verschiedenen Zeiten ermittelten verschiedenen Geschwindigkeitsprofilen eines Fluids codiert sind. Bei der Durchführung der Fourier-Transformation wird für die Rechnung ein Satz von Signalen verwendet, die ein Zeitintervall überdecken, dessen zeitlicher Mittelpunkt um einen kleinen Betrag gegenüber der Mitte des Spin-Echosignales versetzt ist. Infolge dieser Versetzung werden die Bilddaten mit einem Phasenfaktor multipliziert, was zur Folge hat, daß das erzeugte Bild ein von der Phasencodierung durch den n-ten Parameter abhängiges Streifenmuster erhält. Wie ohne weiteres ersichtlich, ist jedoch die Genauigkeit dieses Verfahrens wiederum in hohem Maße von der Genauigkeit der Verschiebung des zeitlichen Mittelpunktes des Zeitintervalles gegenüber der Mitte des Spinechosignales abhängig.

Demgegenüber liegt der Erfindung die Aufgabe zugrunde, ein Verfahren der eingangs genannten Art so zu verbessern, daß es eine Ermittlung und Darstellung des n-ten Parameters mit hoher Genauigkeit gestattet, ohne daß besondere Anforderungen an die Reproduzierbarkeit des Verfahrens zu stellen oder bei der Signalverarbeitung besondere Maßnahmen zu treffen wären.

Diese Aufgabe wird durch die Merkmale des kennzeichnenden Teiles des Anspruches 1 gelöst.

Bei Anwendung des erfindungsgemäßen Verfahrens wird demgemäß keine Linearkombination der den (n-1) Datensätzen zugeordneten Signale gebildet und es findet auch keine sonstige, mehr oder minder aufwendige Manipulation der paarweise aufeinanderfolgenden ersten und zweiten Signale statt, sondern es werden diese Signale einfach als einheitliche Signale behandelt und der Fourier-Transformation unterworfen, so daß sich dann von selbst ein Streifenmuster ergibt, das für den n-ten Parameter charakteristisch ist.

Gegenüber den üblichen Methoden der n-dimensionalen Fourier-NMR-Spektroskopie wird die Anzahl der Meßsequenzen auf diejenige Anzahl reduziert, die zur Aufnahme eines Spektrums der nächst niederen Dimension erforderlich ist. Entsprechend wird die Aufnahmezeit reduziert. Dabei fallen die in der Phase gegeneinander verschobenen Signale bei den gleichen Meßsequenzen an, so daß es auf die Reproduzierbarkeit der bei den einzelnen Meßsequenzen erhaltenen Signale nicht ankommt. Apparative Änderungen und Änderungen im Zustand des Meßobjektes während der Spektrenaufnahme sind daher für das Erfassen der n-ten Dimension nicht mehr von Bedeutung. Weiterhin wird das Streifenmuster ohne zusätzliche Rechenoperation gewonnen und ist leicht interpretierbar. Dabei besteht die Möglichkeit, die Intensität des Streifenmusters durch Wahl der Parameter der Meßsequenzen auf einen Wert einzustellen, der sowohl ein gutes Erkennen des Streifenmusters als auch eine einwandfreie Interpretation der Bilddarstellung gewährleistet.

Wesentlich für die Erfindung ist, daß bei jeder Meßsequenz, die zur Aufnahme des (n-1)-dimensionalen Spektrums benötigt wird, zwei Signale geliefert werden, von denen das eine dem einen und das andere dem anderen der beiden Datensätze zugeordnet ist und die in Richtung der Entwicklung des n-ten Parameters in der Phase gegeneinander verschoben sind.

Diese beiden Signale lassen sich auf verschiedene Weise gewinnen. So können zur Aufnahme der (n-1) Datensätze Impulsfolgen verwendet werden, die als erste und zweite Signale ein direktes bzw. ein stimuliertes Echo liefern. Dabei läßt sich die Intensität des nach der Erfindung erzielten Streifenmusters durch die Größe der Flipwinkel beeinflussen. Insbesondere kann der Flipwinkel des ersten Refokussierimpulses von dem Flipwinkel der folgenden Refokussierimpulse verschieden sein.

Bei einer bevorzugten Ausführungsform der Erfindung bestehen die Meßsequenzen aus Impulsfolgen, die eine Anzahl aufeinanderfolgender Refokussierimpulse aufweisen und bei denen wenigstens einer der Parameter durch einen Feldgradienten kodiert ist, dem nach jedem Echosignal ein Kompensationsgradient zugeordnet ist. Bei den bisher üblichen Verfahren ist der Kompensationsgradient dem Feldgradienten entgegengesetzt gleich, um wieder eine vollständige Rephasierung zu bewirken. Bei dem erfindungsgemäßen Verfahren ist dagegen der n-te Parameter durch Erzeugen eines von dem Feldgradienten verschiedenen Kompensationsgradienten kodiert.

Es besteht aber auch die Möglichkeit, bei der Verwendung von Impulsfolgen, die ein direktes und ein stimuliertes Echo liefern, die Kodierung des n-ten Parameters in dem Zeitintervall zwischen dem ersten und dem zweiten Refokussierungsimpulses vorzunehmen, während dem die Magnetisierung des das stimulierte Signal erzeugenden Anteils als kohärente z-Magnetisierung vorliegt, so daß diese Kodierung nur die Phasenlage des direkten Echos beeinflußt.

Eine weitere Möglichkeit besteht darin, zur Aufnahme der (n-1) Datensätze Impulsfolgen zu verwenden, die als Signale den freien Induktionszerfall und ein Echosignal liefern, von denen nun das erste dem einen und das zweite dem anderen der beiden Datensätze zugeordnet ist. Hier erfolgt die Kodierung des n-ten Parameters in dem Zeitintervall, das dem die Erzeugung des Echosignals bewirkenden Refokussierungsimpuls vorausgeht, in welchem Zeitintervall nur der das Echosignal liefernde Anteil erfaßt wird.

In den zuletzt genannten Fällen kann wiederum die Kodierung des n-ten Parameters durch Anlegen eines entsprechenden Gradienten innerhalb des genannten Zeitintervalles erfolgen.

Wie bereits oben erwähnt, hat das erfindungsgemäße Verfahren eine besondere Bedeutung für die Erfassung eines Stoffeigenschaften angebenden Parameters bei der Bilddarstellung, bei der die n – 1 = 2 Parameter für zwei Richtungen in einer Bildebene charakteristisch sind und der eine Stoffeigenschaft charakterisierende dritte Parameter in Form eines der Bilddarstellung überlagerten Streifenmusters dargestellt wird. So kann insbesondere der n-te Parameter und demgemäß bei der Bilddarstellung der dritte Parameter die Fließgeschwindigkeit des untersuchten Materials oder auch die Änderung seiner örtlichen Suszeptibilität angeben. Die Stoffeigenschaften können aber auch die Umgebung widerspielen, denen der untersuchte Stoff ausgesetzt ist, so daß der n-te Parameter auch beispielsweise die Änderung der Stärke des örtlichen Magnetfeldes oder auch die Änderung der chemischen Verschiebung im Bereich des untersuchten Materials sein kann.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Es zeigen

Fig. 1 Diagramme zur Erläuterung des der Erfindung zugrundeliegenden Prinzips,

Fig. 2 Diagramme zur Erläuterung des Unterschiedes zwischen der Erzeugung einer herkömmlichen Linearkombination und dem erfindungsgemäßen Verfahren,

Fig. 3 das Diagramm einer Impulsfolge, wie sie bei einer Ausführungsform des erfindungsgemäßen Verfahrens Verwendung findet, im Vergleich zu einer Impulsfolge für eine herkömmliche Bilddarstellung,

Fig. 4 ein Diagramm, das die zeitliche Entwicklung der Phase der Transversalmagnetisation bei Anliegen eines Gradientenfeldes und bei Einwirkung eines HF-Impulses wiedergibt,

Fig. 5 ein Diagramm der Phasenentwicklung bei Anwendung der in Fig. 3 dargestellten Impulsfolge,

Fig. 6 ein Diagramm des mittels der Impulsfolge nach Fig. 3 erhalten direkten und stimulierten Echosignals,

Fig. 7 das Diagramm der bei einer weiteren Ausführungsform der Erfindung verwendeten Impulsfolge,

Fig. 8 das Diagramm einer bei einer dritten Ausführungsform des erfindungsgemäßen Verfahrens verwendeten Impulsfolge,

Fig. 9 das nach der Erfindung erhaltene Spektrogramm eines Behälters mit ruhendem Wasser und

Fig. 10 das nach der Erfindung erhaltene Spektrogramm eines von Wasser durchflossenen Schlauches.

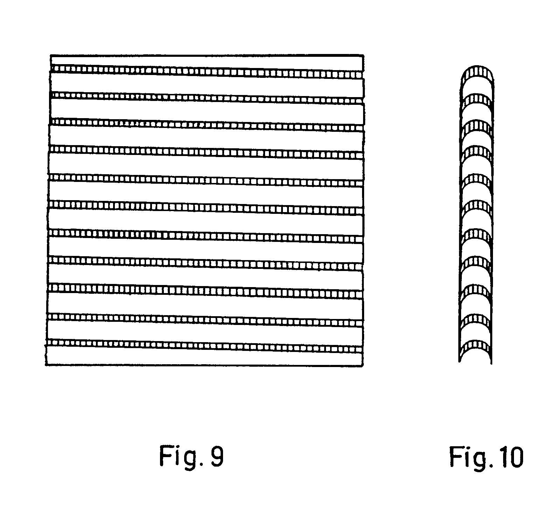

Die Erfindung wird im folgenden für den wichtigsten Anwendungsfall erläutert, nämlich die zweidimensionale Bilddarstellung, welche die Grundlage der NMR-Tomographie bildet. Als Resultat des erfindungsgemäßen Verfahrens wird dann ein NMR-Bild erhalten, auf welches ein Streifenmuster projiziert ist. Der zu messende Parameter stellt sich in einer Änderung des Streifenmusters dar, ohne daß die eigentliche Bildinformation wesentlich beeinflußt ist. Fig. 9 zeigt das Bild eines quadratischen Behälters mit ruhendem Wasser, dem horizontale Streifen überlagert sind. Dagegen zeigt Fig. 10 das Bild eines von Wasser durchflossenen Schlauches, dem parabelförmige Streifen überlagert sind, welche die Flußverhältnisse im Schlauch quantitativ richtig wiedergeben. Es versteht sich, daß neben Flußmessungen auch viele andere Experimente möglich sind, bei denen andere Parameter, wie z.B. die chemische Verschiebung, die magnetische Suszeptibilität, Feldinhomogenitäten usw. als Änderungen in dem projizierten Streifenmuster sichtbar gemacht werden können.

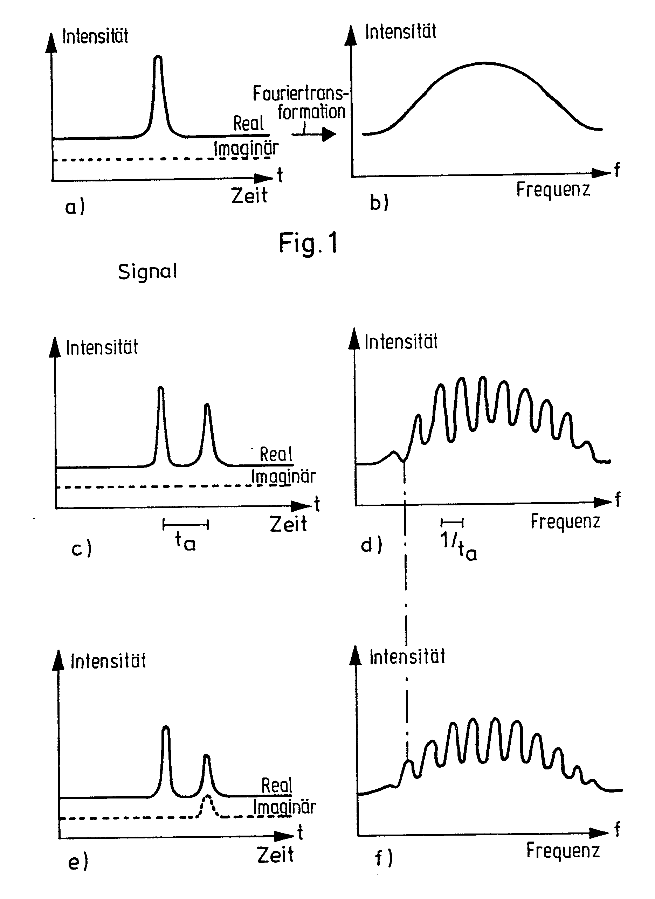

Die Projektion eines Streifenmusters auf ein vorgegebenes Bild ist mit Hilfe von Interferenzbildung möglich. Fig. 1a zeigt ein Signal im Zeitbereich und Fig. 1b dessen Fourier-Transformatierte im Frequenzbereich. Tritt das in Fig. 1a wiedergegebene Signal im Zeitbereich verschoben erneut auf, wie es Fig. 1c zeigt, so ergibt sich nach der Fouriertransformation des verdoppelten Signals nach dem Verschiebungs- theorem der Fouriertransformation die in Fig. 1d dargestellte Linienform, die sich aus der Summe der in Fig. 1b dargestellten Linie und eines Produktes der Fourier-Transformierten des einfachen Signals mit einer Funktion exp $(-i2\pi f t_a)$ darstellt. Dabei ist f die Frequenz der Fourier-Transformierten und $t_a$ der Abstand der beiden Signale im Zeitbereich. Die Bilddarstellung der Fourier-Transformierten ergibt ein Streifenmuster, wie es die Fig. 9 und 10 zeigen. Es ist zu beachten, daß ein enger Abstand der Signale im Zeitbereich aufgrund der reziproken Eigenschaften der Fourier-Transformation einen großen Abstand der Streifen zur Folge hat und umgekehrt.

Aus einer umgekehrten Anwendung des Verschiebungstheorems folgt, daß eine Verschiebung des Streifenmusters, wie sie in Fig. 1f in Bezug auf das Streifenmuster nach Fig. 1d dargestellt ist, dann eintritt, wenn das Signal im Zeitbereich mit einer Funktion exp $(-2i\pi f_a t)$ multipliziert wird, was nichts anderes als die Bildung einer Phasendifferenz zwischen den beiden Zeitsignalen nach Fig. 1c und Fig. 1e bedeutet.

Aus dem Vorstehenden folgt für die NMR-Spektroskopie, daß jedes zur Bilderzeugung verwendete Verfahren, durch welches ein doppeltes Signal erzeugt wird, dessen beiden Einzelsignale eine Phasenverschiebung gegeneinander aufweisen, ein Bild ergibt, welches aus der Überlagerung des Bildes, das man ohne Signalverdoppelung erhält, mit einem Streifenmuster besteht, das ortsabhängig als Funktion des Parameters, der die Phasenänderung bewirkt, verschoben erscheint. Da von Parametern abhängige Phasenänderungen die Grundlage jeder FT-Spektroskopie sind, folgt zwangsläufig, daß jeder Parameter, der sich mit einer beliebigen Methode der FT-Spektros kopie messen läßt, sich auch durch das nach der Erfindung erzeugte Streifenmuster darstellen läßt. Da es sich bei dem erfindungsgemäßen Verfahren um die Erzeugung von Interferenzstreifen handelt, welche die Phasenlage zwischen einander entsprechenden Signalen wiedergeben, kann das erfindungsgemäße Verfahren auch als NMR-Interferometrie bezeichnet werden. Dabei ist besonders darauf hinzuweisen, daß die Signalverdoppelung nicht nur entlang der Zeitachse, also bei der Bilddarstellung in Richtung des Lesegradienten erfolgen kann, sondern auch entlang der zweiten Koordinate, also beispielsweise in Richtung des zur Phasenkodierung dienenden Gradienten. Ebenso ist es ohne weiteres ersichtlich, daß das erfindungsgemäße Verfahren nicht nur auf die Erfassung eines dritten Parameters bei der Bilddarstellung mittels der NMR-Spektroskopie anwendbar ist, sondern daß bei einem beliebigen mehrdimensionalen Verfahren der FT-Spektroskopie ohne nennenswerten Aufwand ein zusätzlicher Parameter erfaßt werden kann.

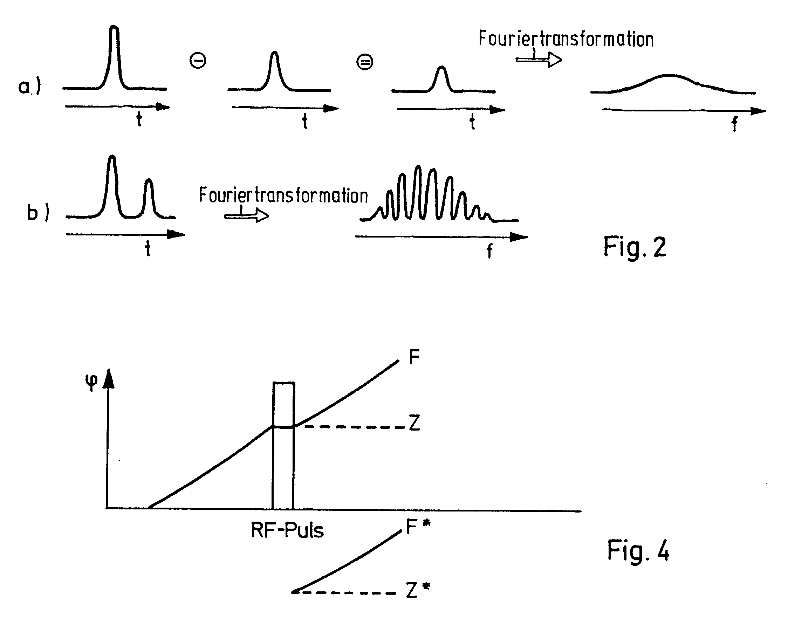

Da das erfindungsgemäße Verfahren ebenso wie das oben behandelte Verfahren, bei dem eine Linearkombination aus zwei Datensätzen erzeugt wird, zwei in Abhängigkeit von einem Parameter modifizierte Signale benutzt, ist es sinnvoll, auf die grundsätzlichen Unterschiede zwischen den beiden Verfahren hinzuweisen. Während zur Bildung einer Linearkombination, wie sie in Fig. 2 dargestellt ist, zwei voneinander unabhängige Signalsätze aufgenommen werden müssen, die dann voneinander subtrahiert werden, bevor das Differenzsignal einer Fourier-Transformation unterworfen wird, werden bei dem erfindungsgemäßen Verfahren, wie nochmals in Fig. 2b dargestellt, die beiden zu kombinierenden Signale bei der Aufnahme eines einzigen Signalsatzes erhalten, der dann ohne zusätzliche Operationen der Fourier-Transformation unterworfen wird. Daraus ergibt sich gegenüber dem bekannten Verfahren nach Fig. 2a nicht nur eine Halbierung der Aufnahmezeit, sondern es sind bei dem erfindungsgemäßen Verfahren keine besonderen Anforderungen an die Reproduzierbarkeit zu stellen. Besonders bedeutungsvoll ist die Tatsache, daß die Amplitude der beiden Signale weitgehend beliebig ist. Ein schwaches zweites Signal führt lediglich dazu, daß das Streifenmuster von geringerer Intensität ist. Die vom Parameter abhängige Verschiebung der Streifen und damit die quantitative Bestimmung des Parameters bleibt davon unberührt. Es ist in vielen Fällen sogar nützlich, das Streifenmuster dem Bild mit nur geringer Intensität zu überlagern, damit die Bildinformation möglichst ungestört erthalten bleibt. Bei der Bildung einer Linearkombination führt dagegen jede Amplitudenmodulation zu drastischen Fehlern bei der Parameterbestimmung.

Da bei der erfindungsgemäßen NMR-Interferometrie die beiden Signale in einer Acquisitionszeit aufgenommen werden, welche bei der NMR-Bilddarstellung eine Dauer im Bereich von 10 bis 20 ms hat, sind apparative oder auch objektabhängige Effekte, die zu einem Meßfehler führe, praktisch ausgeschlossen, da die Änderungen der Meßbedingungen während dieser kurzen Acquisitionszeit stets gering sind. Weiterhin bietet nur das erfindungsgemäße Verfahren die Möglichkeit, Parameteränderungen in einer anderen Richtung als derjenigen der Zeitachse festzustellen.

Zwar läßt sich durch eine rechnerische Verarbeitung der durch aufeinanderfolgende Messungen gewonnenen Signalsätze ebenfalls ein NMR-Interferogramm erzeugen, jedoch gehen dabei die Schnelligkeit und die geringe Fehlerempfindlichkeit verloren, die den Vorteil des erfindungsgemäßen Verfahrens ausmachen.

Ein besonders anschauliches Resultat liefert die erfindungsgemäße NMR-Interferometrie stets dann, wenn der zu bestimmende Parameter eine lineare Phasenänderung und damit eine lineare Verschiebung in dem Streifenmuster bewirkt. Bei komplexeren Phasenänderunen geht die Anschaulichkeit des Resultats verloren. Daher ist die erfindungsgemäße NMR-Interferometrie zur Messung aller derjenigen Größen besonders geeignet, die sich durch einen Parameter charakterisieren lassen, wie z.B. zur Messung der Feldhomogenität, der Suszeptibilität, der Fließgeschwindigkeit, der Diffusion, der Fett/Wasser-Trennung und dgl. Mehrparametrige Größen, wie sie in der Spektroskopie auftreten, sind daher nicht so gut zu erfassen.

Nach dieser Erläuterung der Prinzipien der Erfindung werden anschließend einige spezielle Ausführungsformen des erfindungsgemäßen Verfahrens im einzelnen behandelt.

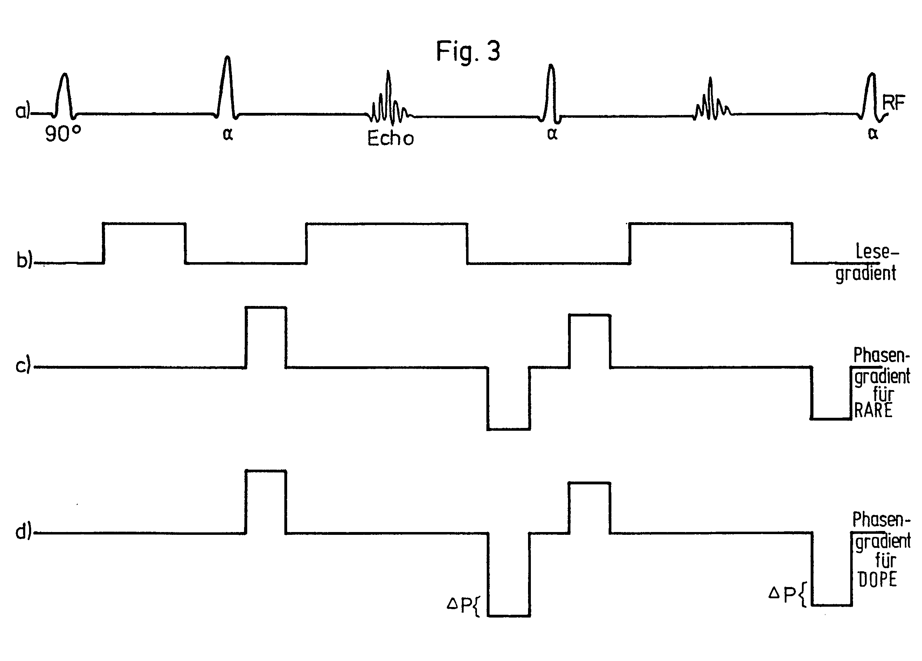

Das anhand Fig. 3 veranschaulichte Verfahren ist besonders dazu geeignet, mit hoher Empfindlichkeit die Geschwindigkeit von fließendem Material zu bestimmen. Grundlage des Verfahrens ist die in Fig. 3a dargestellte Pulssequenz, bei der einem 90°-Impuls eine Anzahl von HF-Impulsen folgt, deren Flipwinkel α von 180° verschieden ist. Diese α-Impulse haben einen Abstand, der doppelt so groß ist wie der Abstand des ersten α-Impulses von dem 90°-Impuls. Im Zeitintervall zwischen den HF-Impulsen ist jeweils, wie bei Verfahren zur Bildaufnahme allgemein üblich, ein Lesegradient eingeschaltet (Fig. 3b). Es handelt sich insoweit um eine herkömmliche Spin-Echo-Impulsfolge, bei der zwischen den α-Impulsen Echosignale auftreten. Zur Bilddarstellung wird in üblicher Weise neben den nicht näher dargestellten Maßnahmen zur Scheibenselektion ein Phasengradient geschaltet, der in Fig. 3c dargestellt ist. Bei den herkömmlichen Verfahren, wie beispielsweise dem bekannten RARE-Verfahren, wird der Phasengradient in dem Intervall zwischen zwei α-Impulsen zweimal, und zwar vor und nach dem Echosignal, mit entgegengesetzten Vorzeichen eingeschaltet, um die für die Erzeugung der Echosignale erforderliche Rephasierung der angeregten Spins zu erreichen.

Das bekannte RARE-Verfahren, wie es die Zeilen a) bis c) der Fig. 3 wiedergeben, erlaubt es, sämtliche zur Bildrekonstruktion benötigten Projektionen im Extremfall mit nur einer Anregung des Spinsystems zu erzeugen.

Das erfindungsgemäße Verfahren unterscheidet sich von dem bekannten RARE-Experiment dadurch, daß die dem 90°-Anregungsimpuls folgenden HF-Impulse keine 180°-Impulse sind, sondern einen von 180° verschiedenen Flipwinkel α erzeugen, wie bereits oben erwähnt. Weiterhin wird die Kompensation des Phasengradienten nach dem Empfang des Echosignals variiert. Im einfachsten Fall geschieht dies dadurch, daß statt der Kompensation mit einem gegengleichen Phasengradienten, wie in Fig. 3c dargestellt, eine Kompensation mit einem Phasengradienten erfolgt, der sich von dem gegengleichen Phasengradienten um einen konstanten Betrag unterscheidet, wie es in Fig. 3d dargestellt ist.

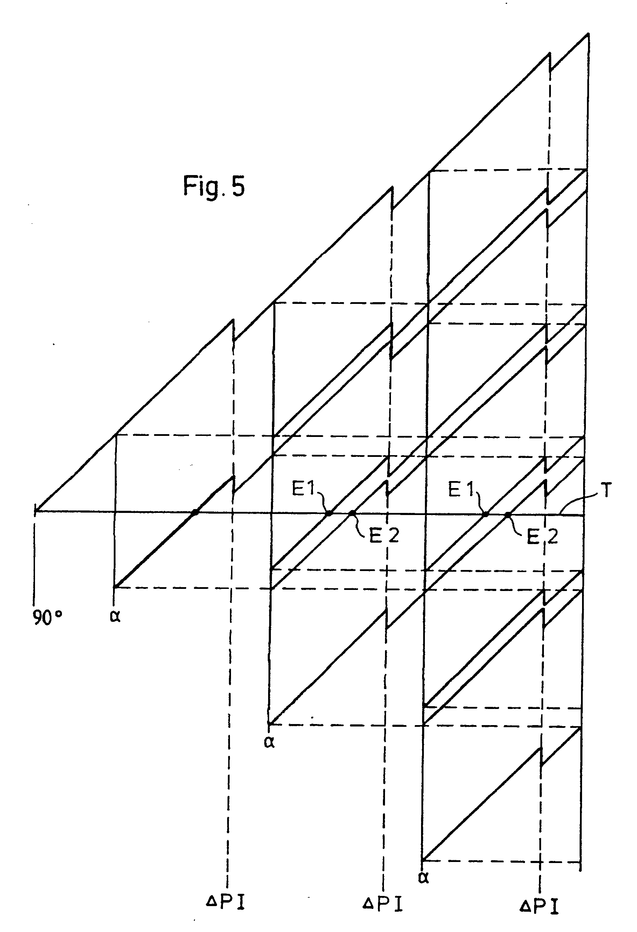

Wie in der eingangs genannten Literaturstelle im einzelnen dargelegt wird, führt eine Refokussierung mittels eines HF-Impulses, dessen Flipwinkel α < 180°, zu einer Aufspaltung der transversalen Magnetisierung in vier Unterzustände, die im Phasendiagramm nach Fig. 4 bildlich dargestellt sind. Wie Fig. 4 zeigt, entwickelt sich ein Teil F der Phase φ der transversalen Magnetisation ungestört, während ein anderer Teil F* invertiert wird. Die beiden weiteren Anteile Z und Z* haben eine kohärente z-Magnetisierung.

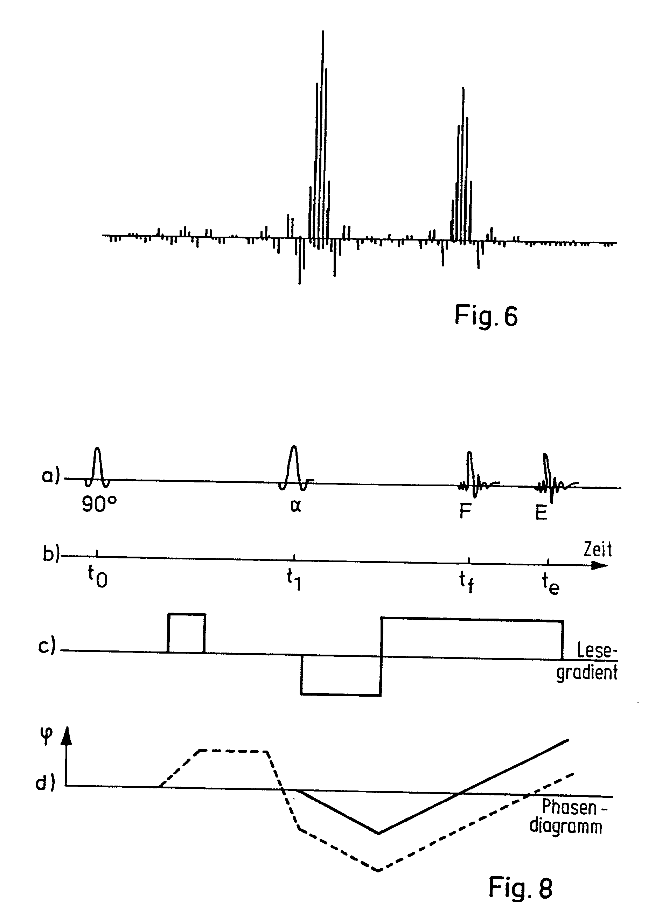

Werden in einer Pulssequenz mehrere solche Refokussierungsimpulse angewendet, so muß der Effekt des Impulses auf jeden dieser Unterzustände berücksichtigt werden. Daher hat das in Fig. 3 gezeigte Experiment unter Verwendung des nicht vollständig kompensierten Phasengradienten nach Fig. 3d das in Fig. 5 dargestellte Entwicklungsdiagramm zur Folge. Dieses Diagramm gibt die wiederholte Aufspaltung der transversalen Magnetisierung in vier Unterzustände bei jedem der nacheinander auftretenden α-Impulse sowie die Phasenverschiebung wieder, die sich aus dem Restbetrag Δ P des nicht vollständig kompensierten Phasengradienten ergeben. Der so gebildete zusätzliche Gradient Δ P hat die Bildung zusätzlicher Zustände zur Folge, die zu einer Verdoppelung der Echos nach dem zweiten α-Impuls führen. Diese Echos ergeben sich aus den Schnittpunkten E1 und E2 mit der Zeitachse T. Als Resultat entsteht eine Verdoppelung des Echozuges, wie er in Fig. 6 dargestellt ist und dessen Einhüllende ein Doppelecho zeigt. Die quantitative Auswertung des Diagrammes nach Fig. 5 führt zu dem Ergebnis, daß das Resultat des Experimentes in einer Überlagerung eines Echozuges, der mit dem Phasengradienten vor dem Echo kodiert ist, und eines Echozuges, der mit dem negativen Phasengradienten nach dem Echo kodiert ist, besteht.

Da unter dem Einfluß von Gradienten eine flußabhängige zusätzliche Dephasierung des NMR-Signales erfolgt, ist die Phase der beiden sich überlagernden Echozüge phasenmoduliert. Entsprechend erfolgt eine Verschiebung der Interferogramm-Linien. Da der maßgebliche Faktor für das Ausmaß der Verschiebung die relative Phasendifferenz der Echos jeweils gleicher Phasenkodierung ist und diese Echos in einem Interferometrie-Experiment in einem zeitlichen Abstand von einer bis mehreren Sekunden aufgenommen werden, folgt daraus eine extrem hohe Empfindlichkeit dieser Ausführunsform des erfindungsgemäßen Verfahrens für fließende Materialien. Die in Fig. 10 dargestellten Flußparabeln entsprechen einer Fließgeschwindigkeit von nur 3 mm/s. Das Verfahren eignet sich daher hervorragend zur Messung sehr kleiner Flußeffekte in reinen Flüssigkeiten, die T2-Relaxationszeiten im Sekundenbereich aufweisen. Da bei dieser Ausführungsform des erfindungsgemäßen Verfahrens von einer doppelten Phasenkodierung (Double-Phase-Encoding) Gebrauch gemacht wird, so soll diese Ausführungsform in Zukunft als DOPE-Verfahren und die dabei verwendete Meßsequenz als DOPE-Sequenz bezeichnet werden.

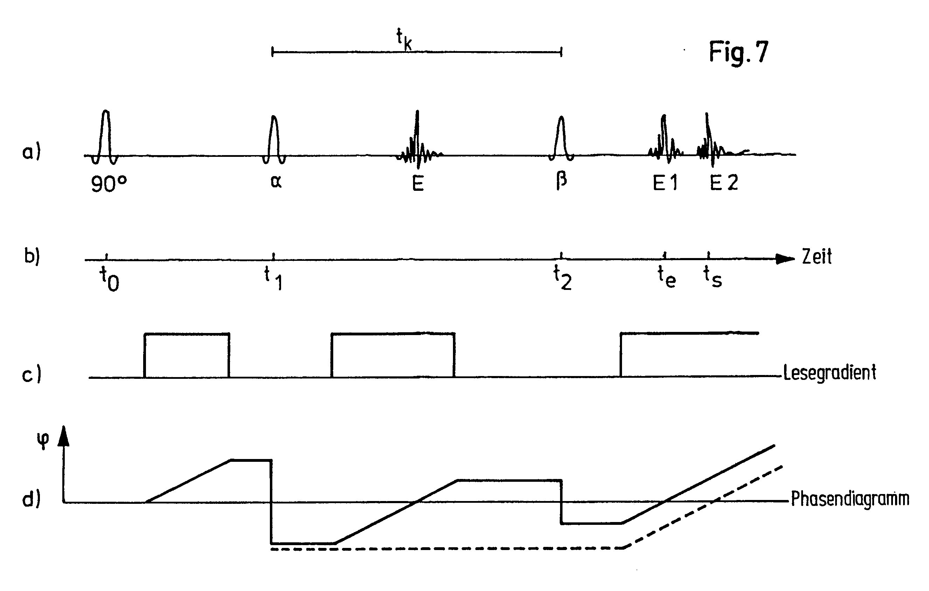

Die erfindungsgemäße Erzeugung eines Doppelsignals läßt sich auch durch Überlagerung eines direkten Echos mit einem Stimulierten Echo erzeugen. Die hierzu erforderliche Sequenz ist in Fig. 7 dargestellt. In Zeile a) ist über der in Zeile b) dargestellten Zeitachse eine Folge von drei HF-Impulsen mit den Flipwinkeln 90°, α und β dargestellt. Eine Variation von α und β hat eine Variation der relativen Signalintensität von stimuliertem und direktem Echo zur Folge. Zeile c) zeigt die Einschaltdauer des in üblicher Weise bei Experimenten zur Bilddarstellung angewendeten Lesegradienten. Endlich ist in Zeile d) ein schematisches Phasendiagramm wiedergegeben, das die Echobildung veranschaulicht. Die durchgezogene Linie entspricht dem Signal, welches zwischen dem ersten und dem zweiten HF-Impuls, also dem 90°-Impuls und dem α-Impuls, eine Dephasierung erhält, durch den α-Impuls invertiert wird, zwischen dem α-Impuls und dem β-Impuls rephasiert, das Echosignal E1 liefert und dann wieder dephasiert. Dieses Signal wird dann vom dritten Impuls wiederum invertiert und bildet nach erneuter Rephasierung wieder ein Echo E1. Der zum stimulierten Echo führende Anteil der Magnetisierung entwickelt sich vor dem α-Impuls und nach dem β-Impuls in der gleichen Weise wie der das Echo E1 liefernde Anteil. Zwischen dem α- Impuls und dem β-Impuls liegt die Magnetisierung jedoch als kohärente z-Magnetisierung vor und erfährt daher keinerlei weitere Phasenevolution. Ist die Phasenentwicklung des zum direkten Echo führenden Signals von solcher Art, daß die Phase dieses Anteils nach dem β-Impuls nicht identisch ist zu der Phase dieses Anteils vor dem α-Impuls, so wird das stimulierte Echo E2 zu einem anderen Zeitpunkt gebildet als das direkte Echo E1 und es entsteht ein Doppelecho. Da die kohärente z-Magnetisierung zwischen dem α-Impuls und dem β-Impuls durch einen Gradienten unbeeinflußt bleibt, kann das Zeitintervall zwischen dem α-Impuls und dem β-Impuls zur Kodierung des mittels der erfindungsgemäßen NMR-Interferometrie zu erfassenden Parameters benutzt werden.

Auch hier bildet wieder eine Flußmessung ein besonders einleuchtendes Beispiel. Es ist bekannt, daß das Signal fließender Materien unter Gradienteneinfluß eine andere Dephasierung erhält als das von stationärem Material stammende Signal. Infolgedessen erfährt das stimulierte Echo in einer Bilderzeugungs-Sequenz eine mehr oder wenige starke Dephasierung, die durch symmetrisches Anlegen zusätzlicher Gradienten vor dem α-Impuls und nach dem β-Impuls noch verstärkt werden kann. In der Zeit zwischen dem α-Impuls und dem β-Impuls angelegte Zusatzgradienten können dazu verwendet werden, jede flußabhängige Phase des Signals des direkten Echos zum Verschwinden zu bringen. Dazu ist für die Gradienten in allen drei Raumrichtungen die Bedingung

$$\int_{t_0}^{t_e} G(t) \cdot x(t) dt = 0$$

zu erfüllen, wenn $t_e$ der Auslösezeitpunkt des Signals und x(t) die zeitabhängige Koordinate des beobachteten Spinpaketes ist. Als Folge davon entsteht eine Phasendifferenz zwischen dem stimulierten und dem direkten Echo, welche sich im NMR-Interferogramm als Verschiebung des Streifenmusters zeigt.

Als Beispiel für die Bestimmung eines anderen Parameters sei noch die Bestimmung der lokalen Feldstärke behandelt. Werden die Gradientenfelder so angelegt, daß das stimulierte Echo E2 zu einer Zeit $T_s$ erscheint, deren Abstand vom Zeitpunkt $t_2$ des Erscheinenes des β-Impulses gleich dem Abstand $t_1 - t_0$ des α-Impulses vom 90°-Impuls ist, so enthält das Signal keinerlei Information über zeitlich konstante Zusatzfelder B, wie sie durch Feldinhomogenitäten, Suszeptibilitätsänderungen oder auch unterschiedliche chemische Verschiebung bei jedem NMR-Experiment vorliegen. Das direkte Echo trägt dagegen eine Dephasierung P, die gegeben ist durch

$$P = 2\pi\gamma B[(t_d - t_3) - (t_2 - t_1) + (t - t_0)].$$

Über geeignete Wahl der Zeitparameter kann so die Empfindlichkeit dieses Experimentes gegenüber B festgelegt und in einem NMR-Interferogramm zur Darstellung gebracht werden. Auf diese Weise können Suszeptibilitätsänderungen, Feldinhomogenitäten und Materialien unterschiedlicher chemischer Zusammensetzung mittels des erfindungsgemäßen Verfahrens dargestellt werden.

Endlich sei auch noch eine Variante des erfindungsgemäßen Verfahrens angegeben, bei dem die Signalerzeugung durch die Überlagerung des freien Induktionszerfalles mit einem Echo erfolgt. Die entsprechende Pulssequenz ist in Fig. 8 dargestellt. Von den beiden Signalen, die zur Bildung des Interferogrammes verwendet werden, entsteht das eine als Echo zweier HF-Impulse mit den Flipwinkeln 90° bzw. α und das andere als freier Induktionszerfall aus dem 90°-Impuls allein. Die Größe der Flipwinkel 90° und α bestimmt wiederum die relative Intensität der beiden Signale. Die Phasenentwicklung der beiden Signale ist wiederum in Zeile d) der Fig. 8 angegeben, während die Zeile a) die HF-Impulse und die Echosignale über der Zeitachse b) wiedergibt und die Zeile c) die Einschaltdauer und Polarität des Lesegradienten anzeigt. Die durchgezogene Linie in dem in Zeile d) wiedergegebenen Phasendiagramm veranschaulicht die Erzeugung eines Signals F durch den freien Induktionszerfall, während die gestrichelte Linie die Erzeugung des direkten Echos E veranschaulicht. Die Zeit zwischen dem 90°-Impuls und dem α-Impuls kann als Evolutionszeit $t_k$ zur Parameterkodierung für die NMR-Interferometrie benutzt werden. Auch hier ist wieder die Darstellung von fließendem Material sowie die Messung lokaler Magnetfelder möglich.

Zur Messung von fließendem Material ist es erforderlich, daß die flußabhängige Dephasierung zwischen direktem Echo E und dem auf den freien Induktionzerfall zurückzuführenden Signal F unterschiedlich ist. Auch hier kann wieder durch geeignete Zusatzgradienten die flußabhängige Dephasierung des freien Induktionzerfalls auf null kompensiert werden, wogegen das ausgelesene Echo E eine flußabhängige Dephasierung aufweist.

Zur Messung lokaler Magnetfelder kann wiederum dafür Sorge getragen werden, daß die Bedingung $t_e - t_1 = t_1 - t_0$ erfüllt ist, daß also das Echosignal E vom α-Impuls den gleichen zeitlichen Abstand hat wie der α-Impuls vom 90°-Impuls. In diesem Fall enthält das direkte Echo keinerlei Information über zeitlich konstante Zusatzfelder. Dagegen enthält das auf den freien Induktionszerfall zurückzuführende Signal F eine Dephasierung der Größe

$$P + 2\pi\gamma B(t_e - t_1).$$

Diese Dephasierung wird durch das NMR-Interferogramm in der beschriebenen Weise wiedergegeben. Umgekehrt kann auch durch Vergrößerung des Abstandes des α-Impulses vom 90°-Impuls eine Dephasierung des Echosignals erreicht werden, welche wesentlich größer ist als die Dephasierung des freien Induktionszerfalls, wodurch die Empfindlichkeit des Experimentes vergrößert werden kann.

Die vorstehenden Ausführungen machen deutlich, daß dem Fachmann durch das erfindungsgemäße Verfahren ein Mittel an die Hand gegeben wird, das es ihm ermöglicht, bei der mehrdimensionalen NMR-Spektroskopie und insbesondere bei der NMR-Bilderzeugung die Größe eines zusätzlichen Parameters mit hoher Genauigkeit zu bestimmen, ohne daß hierfür ein zusätzlicher apparativer Aufwand notwendig wäre. Es werden auch weder die Meßverfahren selbst komplizierter, noch wird ihre Dauer verlängert. Vielmehr lassen sich die bisher in der NMR-Spektroskopie verwendeten Verfahren auf einfache Weise so abwandeln, daß Doppelsignale entstehen, die eine von dem zu bestimmenden Parameter abhängige Phasenkodierung aufweisen und dann ohne weiteres zur Bildung eines Streifenmusters führen, das die örtliche Größe des Parameters angibt.

## Ansprüche

1. Verfahren zum Codieren und Darstellen von n Parametern bei der mehrdimensionalen Fourier-NMR-Spektroskopie, wobei n eine ganze Zahl $\geq 2$ bedeutet, bei dem simultan zwei Datensätze erzeugt werden, die bezüglich (n − 1) Parametern in gleicher Weise codiert, jedoch in Richtung der Entwicklung des n-ten Parameters in der Phase gegeneinander verschoben sind, in dem zur Aufnahme der (n − 1) Datensätze Refokussierimpulse, deren Flipwinkel von 180° verschieden sind, enthaltende Impulsfolgen verwendet werden, die paarweise aufeinanderfolgende erste und zweite Signale liefern, deren relative Phasenlage von der Größe des n-ten Parameters abhängig ist und von denen das erste dem einen und das zweite dem anderen der beiden Datensätze zugeordnet ist, und bei dem durch Fourier-Transformation der den beiden Datensätzen zugeordneten Signale ein für die Größe des n-ten Parameters charakterisisches Signal gewonnen wird, dadurch gekennzeichnet, daß die zu einem Paar gehörenden, ersten und zweiten Signale bei der Fourier-Transformation jeweils als gemeinsames Signal behandelt werden, so daß ein (n − 1) dimensionales Spektrum erhalten wird, dem ein für die Größe des n-ten Parameters charakteristisches Streifenmuster überlagert ist.

2. Verfahren nach Anspruch 1, dadurch gekennzeichnet, daß zur Aufnahme der (n − 1) Datensätze Impulsfolgen verwendet werden, die als erste und zweite Signale ein direktes bzw. ein stimuliertes Echo liefern.

3. Verfahren nach Anspruch 1 oder 2, dadurch gekennzeichnet, daß der Flipwinkel des ersten Refokussierimpulses von dem Flipwinkel der folgenden Refokussierimpulse verschieden ist.

4. Verfahren nach Anspruch 2 oder 3, dadurch gekennzeichnet, daß die Impulsfolge eine Anzahl aufeinanderfolgender Refokussierimpulse aufweist und wenigstens einer der Parameter durch einen Feldgradienten kodiert ist, dem nach jedem Echosignal ein Kompensationsgradient zugeordnet ist, und daß der n-te Parameter durch Erzeugen eines von dem Feldgradienten verschiedenen Kompensationsgradienten kodiert ist.

5. Verfahren nach Anspruch 2 oder 3, dadurch gekennzeichnet, daß die Kodierung des n-ten Parmeters in dem Zeitintervall zwischen dem ersten und dem zweiten Refokussierimpuls erfolgt, während dem die Magnetisierung des das stimulierte Signal erzeugenden Anteils als kohärente z-Magnetisierung vorliegt.

6. Verfahren nach Anspruch 1, dadurch gekennzeichnet, daß zur Aufnahme der (n-1) Datensätze Impulsfolgen verwendet werden, die als erste und zweite Signale den freien Induktionszerfall bzw. ein Echosignal liefern, und daß die Kodierung des n-ten Parameters in dem Zeitintervall erfolgt, das dem die Erzeugung des Echosignales bewirkenden Refokussierimpuls vorausgeht.

7. Verfahren nach Anspruch 5 oder 6, dadurch gekennzeichnet, daß die Kodierung des n-ten Parameters durch Anlegen eines entsprechenden Gradienten innerhalb des genannten Zeitintervalles erfolgt.

8. Verfahren nach einem der vorhergehenden Ansprüche, dadurch gekennzeichnet, daß die (n-1) Parameter für zwei Richtungen in einer Bildebene charakteristisch sind und die Datensätze nach der 2DFT-Methode zu einer Bilddarstellung verarbeitet werden, die von einem einen dritten Parameter veranschaulichenden Streifenmuster überlagert ist.

9. Verfahren nach einem der vorhergehenden Ansprüche, dadurch gekennzeichnet, daß der n-te Parameter die Fließgeschwindigkeit des untersuchten Materials ist.

10. Verfahren nach einem der Ansprüche 1 bis 8, dadurch gekennzeichnet, daß der n-te Parameter die Änderung der örtlichen Suszeptibilität des untersuchten Materials ist.

11. Verfahren nach einem der Ansprüche 1 bis 8, dadurch gekennzeichnet, daß der n-te Parameter die Änderung der Stärke des örtlichen Magnetfeldes im Bereich des untersuchten Materials ist.

12. Verfahren nach einem der Ansprüche 1 bis 8, dadurch gekennzeichnet, daß der n-te Parameter die Änderung der chemischen Verschiebung im Bereich des untersuchten Materials ist.

## Claims

1. Method for encoding and displaying n parameters in multidimensional Fourier NMR spectroscopy, in which n is an integer $\geq 2$, in which simultaneously two data sets are produced, which with respect to (n-1) parameters are encoded in the same way, but are displaced in phase relative to one another in the direction of the development of the nth parameter and for recording the (n-1) data sets use is made of pulse sequences containing refocussing pulses, whose flip angles differ from 180° and which in pairwise succeeding manner supply first and second signals, whose relative phase position is dependent on the value of the nth parameter and whereof the first is associated with one of the two data sets and the second is associated with the other of the said sets, and in which by Fourier transformation of the signals associated with data sets a signal characteristic of the value of the nth parameter is obtained, characterized in that the first and second signals belonging to a pair are in each case treated as a common signal during the Fourier transformation, so that a (n-1) dimensional spectrum is obtained, on which is superimposed the stripe pattern characteristic of the value of the nth parameter.

2. Method according to claim 1, characterized in that for recording the (n-1) data sets use is made of pulse sequences which, as first and second signals, supply a direct or a stimulated echo.

3. Method according to claim 1 or 2, characterized in that the flip angle of the first refocussing pulse differs from the flip angle of the following refocussing pulses.

4. Method according to claim 2 or 3, characterized in that the pulse sequence has a plurality of successive refocussing pulses and at least one of the parameters is encoded by a field gradient with which is associated a compensation gradient following each echo signal and that the nth parameter is encoded by producing a compensation gradient different from the field gradient.

5. Method according to claim 2 or 3, characterized in that the encoding of the nth parameter takes place in the time interval between the first and the second refocussing pulse during which the magnetization of the component generating the stimulated signal is present as a coherent z-magnetization.

6. Method according to claim 1, characterized in that for recording the (n-1) data sets use is made of pulse sequences which, as the first and second signals, supply the free induction decay or an echo signal and that the encoding of the nth parameter takes place in the time interval preceding the refocussing pulse bringing about the generation of the echo signal.

7. Method according to claim 5 or 6, characterized in that the encoding of the nth parameter takes place by applying a corresponding gradient within the said time interval.

8. Method according to one of the preceding claims, characterized in that the (n-1) parameters are characteristic of two directions in an image plane and the data sets are processed according to the 2DFT method to obtain an image on which is superimposed a stripe pattern representing a third parameter.

9. Method according to one of the preceding claims, characterized in that the nth parameter is the flow rate of the matter being examined.

10. Method according to one of the claim 1 to 8, characterized in that the nth parameter is the modification of the local susceptibility of the matter being examined.

11. Method according to one of the claims 1 to 8, characterized in that the nth parameter is the modification of the strength of the local magnetic field in the region of the matter being examined.

12. Method according to one of the claims 1 to 8, characterized in that the nth parameter is the modification of the chemical shift in the region of the matter being examined.

## Revendications

1. Procédé pour coder et représenter n paramètres en spectroscopie de Fourier RMN multidimensionnelle, n étant un nombre entier ≥ 2, et selon lequel on forme simultanément deux ensembles de données codés de la même manière pour ce qui concerne (n-1) paramètres, mais présentant un décalage réciproque de phase en rapport avec le développement du n-ème paramètre, par le fait que pour l'enregistrement des (n-1) ensembles de données, on utilise des suites d'impulsions contenant des impulsions de refocalisation, dont les angles de pivotement sont différents de 180°, et qui délivrent les premier et second signaux, qui se succèdent par couples et dont la position relative dépend de la valeur du paramètre n, le premier étant associé à un premier de deux ensembles de données tandis que le second est associé à l'autre ensemble, et selon lequel on obtient, grâce à la transformation de Fourier appliquée aux signaux associés aux deux ensembles de données, un signal caractéristique de la valeur du n-ème paramètre, caractérisé par le fait qu'on traite les premier et second signaux faisant partie d'un couple, lors de la transformation de Fourier, respectivement sous la forme d'un signal commun de manière à obtenir un spectre à (n-1) dimensions, auquel est superposé un moirage en forme de bandes, caractéristique de la valeur du n-ème paramètre.

2. Procédé suivant la revendication 1, caractérisé par le fait que pour l'enregistrement des (n-1) ensembles de données, on utilise des suites d'impulsions qui fournissent, comme premier et second signaux, un écho direct et un écho stimulé.

3. Procédé suivant la revendication 1 ou 2, caractérisé par le fait que l'angle de pivotement de la première impulsion de refocalisation diffère de l'angle de pivotement des impulsions suivantes de refocalisation.

4. Procédé suivant la revendication 2 ou 3, caractérisé par le fait que la suite d'impulsions possède un nombre d'impulsions successives de refocalisation et qu'au moins l'un des paramètres est codé au moyen d'un gradient de champs, auquel est associé, après chaque signal d'écho, un gradient de compensation, et que le n-ème paramètre est codé au moyen de la production d'un gradient de compensation qui diffère du gradient de champs.

5. Procédé suivant la revendication 2 ou 3, caractérisé par le fait que le codage du n-ème paramètre s'effectue pendant l'intervalle de temps compris entre les première et seconde impulsions de refocalisation, pendant lequel l'aimantation de la partie produisant le signal stimulé est présente sous la forme d'une aimantation cohérente suivant z.

6. Procédé suivant la revendication 1, caractérisé par le fait que pour l'enregistrement des (n-1) ensembles de données, on utilise des suites d'impulsions qui, en tant que premier et second signaux, produisent le signal de déclin de l'aimantation ou un signal d'écho, et que le codage du n-ème paramètre s'effectue pendant l'intervalle de temps qui précède l'impulsion de refocalisation déclenchant la production du signal d'écho.

7. Procédé suivant la revendication 5 ou 6, caractérisé par le fait que le codage du n-ème paramètre est obtenu par application d'un gradient correspondant pendant ledit intervalle de temps.

8. Procédé suivant l'une des revendications précédentes, caractérisé par le fait que les (n-1) paramètres sont caractéristiques de deux directions dans un plan image et que les ensembles de données sont traités selon la méthode 2DFT pour obtenir une représentation d'image à laquelle est superposé un moirage en forme de bandes représentant un troisième paramètre.

9. Procédé suivant l'une des revendications précédentes, caractérisé par le fait que le n-ème paramètre est la vitesse d'écoulement de la substance examinée.

10. Procédé suivant l'une des revendications 1 à 8, caractérisé par le fait que le n-ème paramètre est la variation de la susceptibilité locale de la substance examinée.

11. Procédé suivant l'une des revendications 1 à 8, caractérisé par le fait que le n-ème paramètre est la variation de l'intensité du champ magnétique local dans la région de la substance examinée.

12. Procédé suivant l'une des revendications 1 à 8, caractérisé par le fait que le n-ème paramètre est la variation du déplacement chimique dans la zone de la substance examinée.

Fig. 1

a)

Fouriertransformation

Fig. 2

b)

Fouriertransformation

φ

F

Z

RF-Puls

F*

Z*

Fig. 4

Fig. 3

a) 90° α Echo α α RF

b) Lese-gradient

c) Phasen-gradient für RARE

d) Phasen-gradient für DOPE

ΔP{ ΔP{

EP 0 303 953 B1

Fig. 5

90°

α

E1

E2

E1

E2

T

α

α

ΔPI

ΔPI

ΔPI

Fig. 6

a) 90° α F E

b) t₀ t₁ t_f t_e Zeit

c) Lese-gradient

d) φ Phasen-diagramm

Fig. 8

14

Fig. 7

Fig. 9

Fig. 10